# FASCICULE DE BREVET EUROPEEN

(11) **EP 2 561 373 B1**
(45) Date de publication et mention de la délivrance du brevet: **03.06.2015**
(21) Numéro de dépôt: 11715703.2
(22) Date de dépôt: 19.04.2011
(51) Int. Cl.: G01R 31/28, H01L 23/34

(54) **PROCÉDÉS ET DISPOSITIFS DE MISE SOUS CONTRAINTE D'UN CIRCUIT INTÉGRÉ**
VERFAHREN UND GERÄT ZUR BELASTUNG EINER INTEGRIERTE SCHALTUNG
METHOD AND DEVICE FOR STRESSING AN INTEGRATED CIRCUIT

(30) Priorité: 20.04.2010 FR 1052978
(43) Date de publication de la demande: 27.02.2013
(60) Demande divisionnaire: 15160816.3
(73) Titulaire: Airbus Group SAS, 75016 Paris (FR); Airbus Defence and Space SAS, 78130 Les Mureaux (FR)
(72) Inventeur: MOLIERE, Florian, 92120 MONTROUGE (FR); MORAND, Sébastien, F-92100 Boulogne-Billancourt (FR); DOUIN, Alexandre, 78370 PLAISIR (FR); SALVATERRA, Gérard, F-92140 Clamart (FR); BINOIS, Christian, F-28700 Francourville (FR); PEYRE, Daniel, F-78470 St Remy-lès-Chevreuse (FR)
(74) Mandataire: Ribeiro Dias, Alexandre
(86) Numéro de dépôt international: PCT/EP2011/056235
(87) Numéro de publication internationale: WO 2011/131669

(56) Documents cités:
- EP-A1- 0 069 592
- JP-A- 62 093 965
- US-A- 4 639 829
- US-A- 5 045 914
- US-A1- 2009 174 427
- US-B1- 6 483 326
- "BACKSIDE SILICON INTEGRATED CIRCUIT INFRARED IMMERSION LENS/ HEAT-SINK", IBM TECHNICAL DISCLOSURE BULLETIN, INTERNATIONAL BUSINESS MACHINES CORP. (THORNWOOD), US, vol. 35, no. 7, 1 décembre 1992 (1992-12-01), pages 489-492, XP000333111, ISSN: 0018-8689

## Description

La présente invention appartient au domaine de l'analyse des circuits intégrés, et concerne plus particulièrement les procédures d'analyse du fonctionnement de circuits intégrés soumis à des contraintes thermiques.

Les circuits intégrés, avant leur mise en oeuvre, sont généralement soumis à des procédures d'analyse au cours desquelles ces circuits intégrés sont notamment soumis à des contraintes représentatives des contraintes opérationnelles, c'est-à-dire des contraintes auxquelles ils sont susceptibles d'être confrontés dans leur environnement final.

Ces procédures d'analyse s'avèrent particulièrement importantes, notamment, pour les circuits intégrés amenés à fonctionner dans des environnements très contraints, tels que des circuits intégrés devant être mis en oeuvre dans des missions spatiales et/ou militaires, dans des aéronefs, dans des centrales énergétiques, etc.

Au cours d'une procédure d'analyse, il est courant de soumettre le circuit intégré en fonctionnement à une contrainte thermique, qui correspond par exemple à une contrainte thermique opérationnelle (on parle alors de test de fonctionnement) ou à une contrainte thermique appliquée en vue d'accélérer le vieillissement dudit circuit intégré (on parle alors de test de vieillissement).

Pour appliquer une contrainte thermique à un circuit intégré, il est connu de placer celui-ci, accompagné de son dispositif de test, dans une enceinte fermée équipée d'un système de chauffage ou de refroidissement (voir par exemple la demande de brevet US 2009/174427 A1).

Par « dispositif de test », on entend le dispositif dans lequel le circuit intégré est monté pour en assurer le fonctionnement au cours de la procédure d'analyse. En particulier, le dispositif de test comporte au moins un circuit imprimé, dit « carte mère », sur lequel le circuit intégré est monté directement ou indirectement par l'intermédiaire d'un autre circuit imprimé, dit « carte fille », s'interfaçant avec la carte mère.

D'autres composants électroniques sont montés sur le dispositif de test, et on comprend que ces composants électroniques seront soumis à la même contrainte thermique. En cas de défaillance, il sera difficile d'identifier si le problème provient du circuit intégré testé, ou d'un autre composant électronique du dispositif de test.

Il est connu, pour limiter le problème susmentionné, de monter le circuit intégré à tester sur une carte fille qui est placée dans l'enceinte fermée, et de placer la carte mère à l'extérieur de l'enceinte. Toutefois, cette solution n'est pas applicable aux circuits intégrés fonctionnant à très hautes fréquences (par exemple de l'ordre du gigahertz pour des mémoires SDRAM DDR3 actuelles). En effet, lorsque la carte mère et la carte fille sont éloignées, le temps de propagation des signaux sur l'interface entre la carte mère et la carte fille deviennent beaucoup trop importants, conséquence de capacités parasites sur cette interface.

Un autre problème réside dans le fait que les circuits intégrés se présentent généralement sous la forme d'une puce électronique, au moins en partie en matériau semi-conducteur (silicium, germanium, arséniure de gallium, etc.), encapsulée dans un boîtier muni de connexions externes (broches, matrice à billes, etc.) couplées électriquement à la puce électronique (voir par exemple le brevet US 5045914 A).

La contrainte thermique appliquée au moyen de l'enceinte fermée porte sur la température ambiante à l'intérieur de cette enceinte. Cette contrainte thermique est donc appliquée sur le boîtier, qui est caractérisé par une résistance thermique propre. La température du boîtier est différente de la température de jonction de la puce électronique, alors que, en pratique, c'est cette température de jonction qu'on cherche à maîtriser.

La présente invention a pour objectif de proposer une solution permettant de maîtriser la température de jonction de la puce électronique, sans endommager les composants électroniques voisins.

Un autre objectif de l'invention est de proposer une solution permettant d'appliquer une contrainte thermique locale simultanément à une contrainte de rayonnement. Un autre objectif de l'invention est de proposer une solution applicable à des circuits intégrés de formes et de dimensions différentes.

Selon un premier aspect, l'invention concerne un dispositif de mise sous contrainte d'un circuit intégré comportant une puce électronique montée dans un boîtier, ledit dispositif comportant une source de contrainte thermique. En outre, le dispositif comporte un organe de couplage, thermiquement conducteur, destiné à être couplé thermiquement à la source de contrainte thermique lors de la mise sous contrainte. L'organe de couplage comporte une extrémité de géométrie adaptée à être introduite dans une ouverture de géométrie prédéfinie à réaliser dans le boîtier du circuit intégré, de sorte à coupler thermiquement une face de couplage de cette extrémité avec une face de la puce électronique.

De préférence, l'organe de couplage est de volume extérieur sensiblement tronconique entre deux faces sensiblement parallèles, l'une de ces faces étant la face de couplage et l'autre, de superficie supérieure à celle de ladite face de couplage, étant destinée à être couplée thermiquement à la source de contrainte thermique.

De préférence, le dispositif comporte des moyens de déterminer des caractéristiques structurelles du circuit intégré, et des moyens de réaliser l'ouverture dans le boîtier en fonction desdites caractéristiques structurelles.

De préférence, le dispositif comporte une pluralité d'organes de couplage d'extrémités de géométries différentes.

De préférence, chaque organe de couplage comporte un conduit interne débouchant sur la face de couplage, adapté à fournir un accès optique à la puce électronique lorsque la face de couplage de cet organe de couplage est appliquée contre la puce électronique.

Selon un second aspect, l'invention concerne un procédé de mise sous contrainte d'un circuit intégré comportant une puce électronique montée dans un boîtier. Le procédé comporte :
- une étape de couplage thermique d'une extrémité d'un organe de couplage, thermiquement conducteur, avec une face de la puce électronique, par insertion de ladite extrémité dans une ouverture préalablement ménagée dans le boîtier,
- une étape de mise sous contrainte thermique de la puce électronique au moyen d'une source de contrainte thermique couplée thermiquement à l'organe de couplage.

De préférence, le procédé comporte une étape préalable de réalisation de l'ouverture par usinage du boîtier.

De préférence, le procédé comporte une étape de détermination de caractéristiques structurelles du circuit intégré, l'ouverture dans le boîtier étant réalisée en fonction desdites caractéristiques structurelles.

De préférence, le procédé comporte une étape de sélection d'un organe de couplage, parmi une pluralité d'organes de couplage d'extrémités de géométrie différente, adapté à être introduit dans l'ouverture du boîtier.

De préférence, le procédé comporte une étape de mise sous contrainte de rayonnement de la puce électronique à travers l'ouverture ménagée dans le boîtier, de préférence via un conduit interne de l'organe de couplage.

L'invention sera mieux comprise à la lecture de la description suivante, donnée à titre d'exemple nullement limitatif, et faite en se référant aux figures qui représentent :
- Figures 1 a et 1 b : des représentations schématiques de coupes d'exemples de circuits intégrés,
- Figure 2 : une représentation schématique d'une coupe d'un exemple de réalisation d'un dispositif de mise sous contrainte,
- Figures 3a à 3e : des diagrammes illustrant des exemples de mise en oeuvre d'un procédé de mise sous contrainte selon l'invention,
- Figures 4a et 4b : des représentations schématiques de coupes de variantes de réalisation du dispositif de la figure 2.

La présente invention concerne la mise sous contrainte de circuits intégrés, et concerne plus particulièrement la mise sous contrainte thermique accompagnée, dans certains cas, d'une contrainte de rayonnement.

Par « contrainte de rayonnement », on entend tout type de rayonnement connu pour la mise sous contrainte de circuits intégrés. Il s'agit par exemple d'un rayonnement photonique (laser, X, gamma, etc.) et/ou d'un rayonnement ionisant (alpha, protons, neutrons, ions lourds, etc.).

L'invention est applicable à tout circuit intégré comportant une puce électronique montée à l'intérieur d'un boîtier muni de connexions externes.

L'invention est donc applicable à des composants électroniques de formes très variées, notamment des composants traversant (DIL, etc.), ou montés en surface à broches (SOJ, PLCC, SOP, QFP, etc.), à matrices de billes (ou BGA pour « Ball Grid Array »), etc.

L'invention est également indépendante de la technologie mise en oeuvre pour coupler électriquement la puce électronique aux connexions externes, et peut être appliquée aux circuits à câblage par fils (« pontage » ou « bonding » dans la littérature anglo-saxonne) ou à puce retournée (« flip chip »).

L'invention est donc applicable à des composants électroniques de fonctions très variées (composants analogiques, composants digitaux, composants de puissance, mémoires électroniques, microprocesseurs, etc.). Par abus de langage, on inclut également, dans la catégorie des circuits intégrés, les composants discrets.

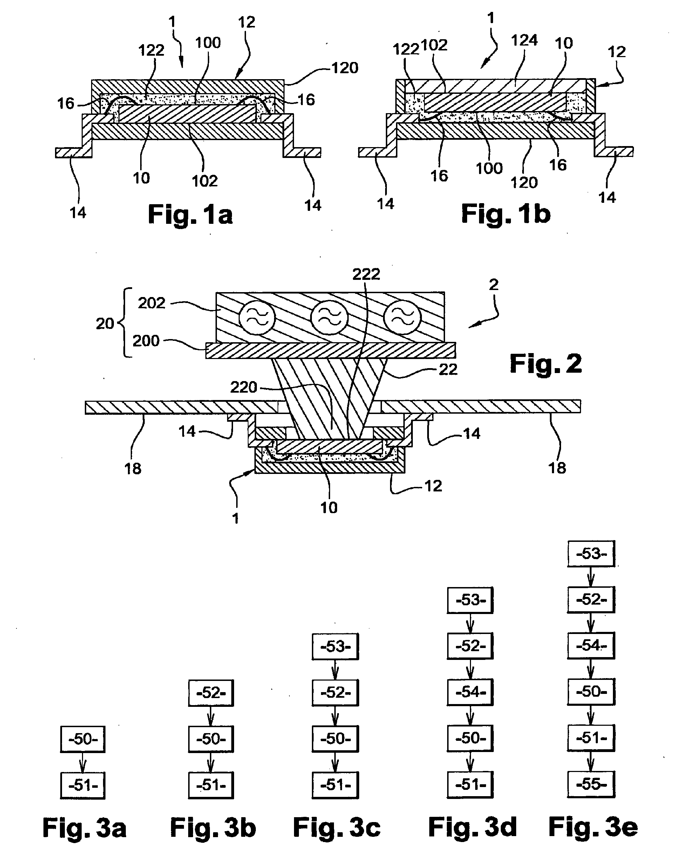

La figure 1a représente, de façon très schématique, une coupe d'un premier exemple de circuit intégré 1 du type câblé par fil (« bonding »).

Le circuit intégré 1 comporte une puce électronique 10 en matériau semi-conducteur (silicium, germanium, arséniure de gallium, etc.).

La puce électronique 10 est sensiblement en forme de plaque comportant deux faces opposées. En principe, l'une des faces, dite « face fonctionnelle » 100, porte les circuits électroniques. La face opposée, dite « face non-fonctionnelle » 102, ne porte pas de circuits électroniques et correspond généralement au substrat de la puce électronique 10.

La puce électronique 10 est montée dans un boîtier 12.

Dans le contexte de l'invention, on entend par « boîtier » 12 tout élément empêchant un accès mécanique à la puce électronique 10. Le boîtier inclut par exemple une coque externe 120, une résine d'encapsulation 122, etc.

Dans la suite de la description, on entend, par « intérieur » du boîtier 12, la partie du boîtier dans laquelle se trouve la puce électronique 10. L'extérieur du boîtier 12 est par opposition la partie du boîtier dans laquelle ne se trouve pas ladite puce électronique.

Le boîtier 12 comporte principalement, vu de l'extérieur, deux faces frontales reliées entre elles par une ou plusieurs faces latérales. Les faces frontales sont sensiblement parallèles aux faces de ladite puce électronique.

Le circuit intégré 1 comporte des connexions externes 14 (broches) qui sont reliées électriquement aux entrées/sorties de la puce électronique 10 par des fils de connexion 16.

La figure 1b représente, de façon très schématique, une coupe d'un second exemple de circuit intégré 1, comportant sensiblement les mêmes éléments que celui représenté sur la figure 1 a.

Le circuit intégré 1 de la figure 1b se distingue par la présence d'un dissipateur thermique 124, couplé thermiquement à la face non-fonctionnelle 102 de la puce électronique 10, et par le fait que sa puce électronique est retournée.

Le dissipateur thermique 124 est au moins en partie accessible depuis l'extérieur du boîtier 12. Dans l'exemple de la figure 1b, le dissipateur thermique 124 constitue l'une des faces frontales du boîtier 12.

La figure 2 représente un mode préféré de réalisation d'un dispositif 2 de mise sous contrainte d'un circuit intégré 1.

Suivant ce mode préféré de réalisation, le dispositif 2 comporte une source 20 de contrainte thermique, qui peut être de tout type connu.

De préférence, la source 20 de contrainte thermique comporte un module thermoélectrique 200, tel qu'un module Peltier.

Un module Peltier comporte généralement deux faces opposées. Lorsqu'il est alimenté en courant, l'une de ses faces, dite « face chaude », va s'échauffer, tandis que l'autre face, dite « face froide », va se refroidir.

De préférence, la source 20 de contrainte thermique comporte également un module thermorégulateur 202, qui peut être de tout type connu. Il s'agit par exemple d'un module thermorégulateur à circulation de fluide caloporteur (eau, huile, etc.), mis en oeuvre pour réguler la température d'une face du module Peltier, la face froide si l'on souhaite appliquer une contrainte de chaleur au circuit intégré 1.

Le dispositif 2 de mise sous contrainte comporte également un module de contrôle, non représenté sur les figures, qui pilote le fonctionnement de la source 20 de contrainte thermique.

Le module de contrôle comporte par exemple un micro-ordinateur relié à des moyens de mémorisation (disque dur magnétique, mémoire RAM et/ou ROM, disque optique, etc.) par un bus de communication. Un produit programme d'ordinateur est mémorisé dans les moyens de mémorisation, sous la forme d'un ensemble d'instructions de code de programme qui, lorsqu'elles sont exécutées par le micro-ordinateur, permettent le contrôle de la température appliquée par la source 20 de contrainte thermique. Suivant certains modes de réalisation, le module de contrôle comporte également des circuits électroniques spécialisés, de type ASIC, FPGA, etc.

Le dispositif 2 comporte également un organe 22 de couplage. L'organe 22 de couplage comporte une zone de raccord destinée à être couplée thermiquement à la source 20 de contrainte thermique lors de la mise sous contrainte du circuit intégré 1.

L'organe 22 de couplage est, en tout ou partie, réalisé en matériau thermiquement conducteur, par exemple en cuivre ou en alliage de cuivre, en aluminium ou en alliage d'aluminium, etc. L'organe 22 de couplage est thermiquement conducteur entre la zone de raccord à la source 20 de contrainte thermique et une extrémité 220.

L'extrémité 220 de l'organe 22 de couplage est adaptée, par sa géométrie, à être introduite dans une ouverture préalablement ménagée dans le boîtier 12 du circuit intégré 1 à mettre sous contrainte, ladite ouverture permettant un accès mécanique à une face de la puce électronique 10. Par « géométrie » de l'extrémité 220, on entend son volume extérieur, c'est-à-dire sa forme et ses dimensions. Par « accès mécanique à une face de la puce électronique », on entend qu'un organe de couplage dont l'extrémité est de géométrie adaptée à être introduite dans ladite ouverture peut venir prendre appui sur ladite face de la puce électronique 10.

L'ouverture préalablement ménagée dans le boîtier 12 permet d'accéder mécaniquement à tout ou partie d'une face de la puce électronique 10, avec laquelle une face de couplage 222 de l'extrémité 220 est couplée thermiquement lors de la mise sous contrainte du circuit intégré 1.

La face de couplage 222 est de préférence sensiblement complémentaire de la face de la puce électronique 10 avec laquelle elle doit être couplée thermiquement, en particulier lorsque la face de couplage 222 est destinée à prendre appui sur ladite face de la puce électronique 10.

De préférence, la face de couplage 222 est destinée à être couplée thermiquement à la face non-fonctionnelle 102 de la puce électronique 10. C'est le cas considéré dans la suite de la description. En outre, on considère le cas où la face non-fonctionnelle 102 est sensiblement plane, et la face de couplage 222 est également sensiblement plane.

Il est à noter que rien n'exclut, suivant d'autres exemples, de coupler l'extrémité 220 de l'organe 22 de couplage avec la face fonctionnelle 100 de la puce électronique 10. Toutefois, cela s'avère en pratique complexe du fait des risques de court-circuit (dans le cas où l'organe 22 de couplage est en matériau électriquement conducteur) et/ou du fait des risques d'endommager les circuits électroniques de la face fonctionnelle 100. En outre, lorsque la face fonctionnelle 100 est en partie couverte d'oxydes intermétalliques, la conduction thermique entre l'organe 22 de couplage et la puce électronique 10 peut s'avérer insuffisante.

Le couplage entre d'une part l'organe 22 de couplage et la source 20 de contrainte thermique, et d'autre part la face de couplage 222 dudit organe de couplage et la puce électronique 10, peut être direct ou indirect. En cas de couplage direct, celui-ci s'effectue sans éléments intermédiaires, les éléments couplés thermiquement étant alors au contact l'un de l'autre. En cas de couplage indirect, celui-ci s'effectue par l'intermédiaire d'un ou de plusieurs autres éléments intermédiaires tous thermiquement conducteurs et couplés directement. Par exemple en utilisant une graisse thermique et/ou une plaque mince en saphir (adaptée, le cas échéant, à être introduite dans l'ouverture préalablement ménagée dans le boîtier 12). On note que l'air ambiant n'est pas un élément intermédiaire permettant un couplage thermique indirect dans l'a mesure où l'air ambiant est un isolant thermique.

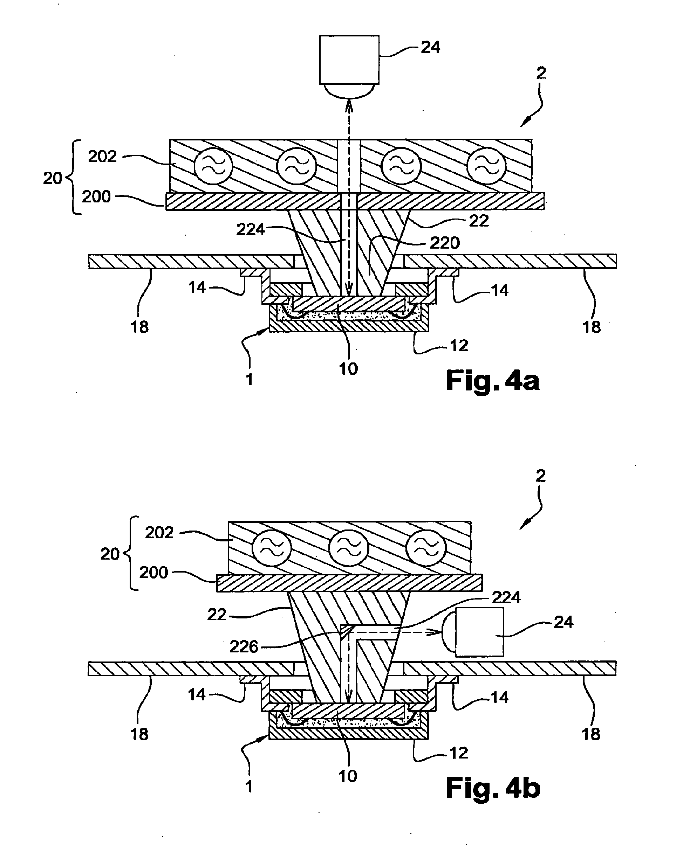

De préférence, l'organe 22 de couplage est un corps plein, pour assurer une diffusion homogène de la contrainte thermique. Rien n'exclut, suivant certains modes de réalisation dont certains seront décrits en référence aux figures 4a et 4b, que l'organe 22 de couplage comporte une ou des cavités internes, un ou des conduits internes, etc.

Dans un exemple préféré de réalisation, illustré par la figure 2, l'organe 22 de couplage est de volume extérieur sensiblement tronconique entre deux faces sensiblement parallèles. L'une de ces faces est la face de couplage 222 et l'autre correspond à la zone de raccord de l'organe 22 de couplage. La zone de raccord est de superficie supérieure à celle de ladite face de couplage afin d'augmenter la surface disponible pour le couplage thermique avec la source 30 de contrainte thermique.

La figure 3a représente les étapes principales d'un procédé de mise sous contrainte d'un circuit intégré 1 mettant en oeuvre le dispositif 2.

Tel qu'illustré par la figure 3a, le procédé de mise sous contrainte comporte principalement les étapes suivantes :
- une étape 50 de couplage thermique de l'extrémité 220 de l'organe de couplage avec la face non-fonctionnelle 102 de la puce électronique 10, par insertion de ladite extrémité 220 dans une ouverture préalablement ménagée dans le boîtier 12.
- une étape 51 de mise sous contrainte thermique de la puce électronique 10 du circuit intégré 1, au cours de laquelle on applique une température sur la puce électronique 10 au moyen de la source 20 de contrainte thermique, couplée thermiquement à l'organe 22 de couplage.

Le dispositif 2 comporte de préférence des moyens de réaliser l'ouverture dans le boîtier 12, non représentés sur les figures. Les moyens de réaliser une ouverture dans le boîtier se présentent par exemple sous la forme d'une machine-outil adaptée à usiner le boîtier 12 (fraiseuse, etc.). Ces moyens doivent être suffisamment précis pour permettre de mettre à nu, sans l'endommager, la puce électronique 10 du circuit intégré 1.

De préférence, il s'agit d'une machine-outil à commande numérique, adaptée à réaliser des ouvertures de formes et/ou de dimensions différentes, en fonction d'une consigne donnée. La machine-outil est par exemple portée par des moyens permettant d'en assurer le déplacement (robot articulé, unités de translation motorisées, etc.) et/ou la machine-outil comporte une pluralité de têtes d'usinage interchangeables de géométrie différente.

Tel qu'illustré par la figure 3b, le procédé de mise sous contrainte comporte dans ce cas une étape 52 préalable de réalisation de l'ouverture dans le boîtier 12 du circuit intégré 1, de sorte à mettre à nu tout ou partie de ladite face non-fonctionnelle 102, et permettre ainsi un accès mécanique à ladite face non-fonctionnelle.

Il est à noter que, le circuit intégré 1 étant généralement monté sur un circuit imprimé 18, il pourra s'avérer nécessaire de prévoir ou de réaliser une ouverture dans ce circuit imprimé.

Par exemple, si le circuit intégré 1 est câblé par fils (« bonding »), la face non-fonctionnelle 102 se retrouvera en général du côté du circuit imprimé, et ne sera accessible qu'à condition de prévoir ou de réaliser une ouverture dans ce circuit imprimé. Ce cas est illustré par les figures 2, 4a et 4b.

Rien n'exclut de réaliser l'ouverture dans le circuit imprimé 18 en même temps que l'ouverture dans le boîtier 12, c'est-à-dire au cours de la même opération d'usinage exécutée après que le circuit intégré 1 a été monté sur le circuit imprimé 18. De préférence, le circuit imprimé 18 et le boîtier 12 sont ouverts séparément, en particulier l'ouverture dans le circuit imprimé 18 est réalisée avant de monter le circuit intégré 1 sur ce circuit imprimé.

Lorsque le circuit intégré 1 est à puce retournée, la face non-fonctionnelle 102 se retrouvera en général du côté opposé au circuit imprimé 18, et il ne sera alors pas nécessaire de réaliser une ouverture dans ce circuit imprimé.

On comprend que, du fait de la réalisation préalable d'une ouverture dans le boîtier 12 du circuit intégré 1, et du fait de l'utilisation de l'organe 22 de couplage de géométrie adaptée, on assure que la contrainte thermique, générée par la source 20 de contrainte thermique, est transmise à la puce électronique 10. On assure donc une meilleure maîtrise de la température de jonction de ladite puce électronique.

Avantageusement, la géométrie de l'ouverture réalisée est déterminée en fonction de caractéristiques structurelles du circuit intégré. Par « géométrie de l'ouverture », on entend le volume à usiner du boîtier, c'est-à-dire sa forme et ses dimensions, pour assurer un accès mécanique total ou partiel à la face non-fonctionnelle 102 de la puce électronique 10.

Par « caractéristiques structurelles du circuit intégré », on entend au moins l'une des caractéristiques suivantes : la forme de la puce électronique 10, les dimensions de la face non-fonctionnelle 102 de la puce électronique 10, l'épaisseur du boîtier 12, la configuration interne du circuit intégré 1 (afin de déterminer notamment laquelle des faces frontales doit être usinée pour fournir un accès mécanique à la face non-fonctionnelle 102 de la puce 10), etc.

Dans une variante, le dispositif 2 de mise sous contrainte comporte des moyens de déterminer les caractéristiques structurelles du circuit intégré 1. Ces moyens ne sont pas représentés sur les figures.

De préférence, les moyens de déterminer des caractéristiques structurelles comportent un module de contrôle non-destructif, par exemple un module à rayons X.

Tel qu'illustré par la figure 3c, le procédé de mise sous contrainte comporte dans ce cas une étape 53 de détermination de caractéristiques structurelles du circuit intégré 1 à mettre sous contrainte, préalable à l'étape 52 de réalisation de l'ouverture.

Suivant une variante, le dispositif 2 comporte une pluralité d'organes 22 de couplage dont les extrémités 220 sont de géométries différentes. Ces organes 22 de couplage sont de préférence interchangeables, c'est-à-dire qu'ils peuvent couplés alternativement à la source 20 de contrainte thermique.

Tel qu'illustré par la figure 3d, le procédé de mise sous contrainte comporte dans ce cas une étape 54 de sélection d'un organe 22 de couplage parmi la pluralité d'organes 22 de couplage, adapté la mise sous contrainte du circuit intégré 1.

L'organe 22 de couplage est sélectionné en fonction de la géométrie de l'ouverture, dans la mesure où l'organe 22 de couplage sélectionné doit être adapté à être introduit dans l'ouverture ménagée dans le boîtier.

De préférence, l'organe 22 de couplage est également sélectionné en fonction de caractéristiques structurelles du circuit intégré 1.

Par exemple, la sélection consiste à déterminer, parmi les organes 22 de couplage disponibles, l'organe 22 de couplage qui, tout en étant adapté à être introduit dans l'ouverture réalisée, maximise la surface de contact (et donc la surface de transfert thermique) avec la face non-fonctionnelle 102.

On comprend qu'un tel dispositif 2 pourra être mis en oeuvre pour mettre sous contrainte des circuits intégrés de caractéristiques structurelles différentes.

Dans une variante, le dispositif 2 comporte également une source 24 de contrainte de rayonnement, de type connu, tel qu'une source laser.

Tel qu'illustré par la figure 3e, le procédé de mise sous contrainte comporte dans ce cas une étape 55 de mise sous contrainte de rayonnement de la puce électronique 10, au cours de laquelle on applique un rayonnement sur la puce électronique 10 à travers l'ouverture ménagée dans le boîtier 12.

Il est à noter que les étapes 50 de mise sous contrainte thermique et 55 de mise sous contrainte de rayonnement sont de préférence exécutées simultanément.

De préférence, chaque organe 22 de couplage comporte un conduit interne 224 débouchant sur la face de couplage 222 de son extrémité, adapté à fournir un accès optique à la puce électronique 10 lorsque la face de couplage 222 de cet organe de couplage est appliquée contre la face non-fonctionnelle 102 de la puce électronique 10.

Par « accès optique », on entend un accès adapté à laisser passer une contrainte de rayonnement, par exemple un rayon laser, jusqu'à la puce électronique 10.

Cet accès optique, fourni par le conduit interne 224 d'un organe 22 de couplage, permet d'appliquer la contrainte de rayonnement sur la puce électronique 10 du circuit intégré 1, à travers l'organe de couplage.

Les figures 4a et 4b représentent schématiquement des exemples de réalisation d'un organe 22 de couplage comprenant un conduit interne 224.

Sur la figure 4a, le conduit interne 224 est sensiblement rectiligne, et débouche dans la zone de raccord à la source 20 de contrainte thermique. Dans l'exemple non limitatif illustré par la figure 4a, le module thermoélectrique 200 comporte également une ouverture, dans le prolongement du conduit interne 224, pour appliquer la contrainte de rayonnement à travers le module thermoélectrique 200.

Sur la figure 4b, le conduit interne 224 comporte deux parties communicantes se rejoignant en formant un angle sensiblement droit. Un élément 226 réfléchissant, tel qu'un miroir, est agencé au niveau de la jonction. L'élément 226 réfléchissant est orienté sensiblement à 45 degrés, de sorte que, dans le cas notamment d'un rayon laser, un rayon laser incident dans une première partie du conduit interne 224 est réfléchi en direction de la seconde partie du conduit interne 224.

De manière plus générale, la portée de la présente invention ne se limite pas aux modes de mise en oeuvre et de réalisation décrits ci-dessus à titre d'exemples non limitatifs.

On comprend notamment que la contrainte thermique appliquée peut être une contrainte de chaleur ou une contrainte de froid. Ceci est par exemple obtenu en inversant la polarité du module Peltier. Le module thermorégulateur régule la température de la face froide dans le cas d'une mise sous contrainte de chaleur, la face chaude dans le cas d'une mise sous contrainte de froid.

On note que l'invention porte sur l'analyse du comportement d'un circuit intégré lorsqu'il est soumis à une contrainte, notamment une contrainte thermique. Les différentes étapes des procédés de mise sous contrainte thermique sont généralement suivies d'étapes d'excitation du circuit intégré et d'analyse du comportement dudit circuit intégré afin de déterminer l'influence des contraintes appliquées. Ces étapes sont considérées connues de l'homme du métier, et ne sont pas représentées sur les figures.

En outre, le module de contrôle, qui pilote le fonctionnement de la source de contrainte thermique et, le cas échéant, de la source de contrainte de rayonnement, est alors configuré pour analyser le comportement du circuit intégré en réponse aux contraintes appliquées.

## Revendications

1. Dispositif (2) de mise sous contrainte d'un circuit intégré (1) comportant une puce électronique (10) montée dans un boîtier (12), le dispositif comportant une source (20) de contrainte thermique, et étant **caractérisé en ce qu'**il comporte un organe (22) de couplage, thermiquement conducteur, destiné à être couplé thermiquement à la source (20) de contrainte thermique lors de la mise sous contrainte, et **en ce que** l'organe (22) de couplage comporte une extrémité (220) de géométrie adaptée à être introduite dans une ouverture de géométrie prédéfinie à réaliser dans le boîtier (12) du circuit intégré (1), ladite ouverture permettant un accès mécanique à une face (102) de la puce électronique (10), de sorte à coupler thermiquement une face de couplage (222) de cette extrémité (220) avec ladite face (102) de la puce électronique (10).

2. Dispositif (2) selon la revendication 1, **caractérisé en ce que** l'organe (22) de couplage est de volume extérieur sensiblement tronconique entre deux faces sensiblement parallèles, l'une de ces faces étant la face de couplage (222) et l'autre, de superficie supérieure à celle de ladite face de couplage, étant destinée à être couplée thermiquement à la source (20) de contrainte thermique lors de la mise sous contrainte.

3. Dispositif (2) selon l'une des revendications 1 à 2, **caractérisé en ce qu'**il comporte des moyens de déterminer des caractéristiques structurelles du circuit intégré (1), et des moyens de réaliser l'ouverture dans le boîtier (12) en fonction desdites caractéristiques structurelles.

4. Dispositif (2) selon l'une des revendications précédentes, **caractérisé en ce qu'**il comporte une pluralité d'organes (22) de couplage d'extrémités (220) de géométries différentes.

5. Dispositif (2) selon l'une des revendications précédentes, **caractérisé en ce que** chaque organe (22) de couplage comporte un conduit interne (224) débouchant sur la face de couplage (222) de son extrémité (220), adapté à fournir un accès optique à la puce électronique (10) lorsque la face de couplage de cet organe de couplage est appliquée contre une face (102) de la puce électronique (10).

6. Procédé de mise sous contrainte d'un circuit intégré (1) comportant une puce électronique (10) montée dans un boîtier (12), **caractérisé en ce qu'**il comporte :
- une étape (50) de couplage thermique d'une extrémité (220) d'un organe de couplage, thermiquement conducteur, avec une face (102) de la puce électronique (10), par insertion de ladite extrémité dans une ouverture préalablement ménagée dans le boîtier (12), ladite ouverture permettant un accès mécanique à ladite face (102) de la puce électronique (10),
- une étape (51) de mise sous contrainte thermique de la puce électronique (10) au moyen d'une source (20) de contrainte thermique couplée thermiquement à l'organe (22) de couplage.

7. Procédé selon la revendication 6, comportant une étape (52) préalable de réalisation de l'ouverture par usinage du boîtier (12) du circuit intégré (1).

8. Procédé selon la revendication 7, **caractérisé en ce qu'**il comporte une étape (53) de détermination de caractéristiques structurelles du circuit intégré (1), l'ouverture dans le boîtier (12) étant réalisée en fonction desdites caractéristiques structurelles.

9. Procédé selon l'une des revendications 6 à 8, **caractérisé en ce qu'**il comporte une étape (54) de sélection d'un organe (22) de couplage, parmi une pluralité d'organes (22) de couplage d'extrémités de géométrie différente, adapté à être introduit dans l'ouverture du boîtier (12).

10. Procédé selon l'une des revendications 6 à 9, **caractérisé en ce qu'**il comporte une étape (55) de mise sous contrainte de rayonnement de la puce électronique (10) à travers l'ouverture ménagée dans le boîtier (12) du circuit intégré (1), de préférence au travers d'un conduit interne (224) de l'organe (22) de couplage, ledit conduit interne débouchant sur la face de couplage (222) de l'extrémité (220) de l'organe de couplage.

## Patentansprüche

1. Vorrichtung (2) zur Belastung eines integrierten Schaltkreises (1) einen Elektronik-Chip (10) umfassend, der in einem Gehäuse (12) montiert ist, wobei die Vorrichtung eine Quelle (20) zur thermischen Belastung umfasst und **dadurch gekennzeichnet ist, dass** es ein wärmeleitendes Koppelglied (22) umfasst, das dazu bestimmt ist, bei der Belastung thermisch an die Quelle (20) zur thermischen Belastung gekoppelt zu werden, und dadurch, dass das Koppelglied (22) ein Ende (220) mit einer Geometrie umfasst, die sich dazu eignet, in eine Öffnung mit einer vorbestimmten Geometrie eingeführt zu werden, die im Gehäuse (12) des integrierten Schaltkreises (1) zu erstellen ist, wobei die besagte Öffnung einen mechanischen Zugriff auf eine Seite (102) des Elektronik-Chips (10) zulässt, um eine Koppelseite (222) dieses Endes (220) thermisch an die besagte Seite (102) des Elektronik-Chips (10) zu koppeln.

2. Vorrichtung (2) nach Anspruch 1, **dadurch gekennzeichnet, dass** das Koppelglied (22) ein in etwa kegelförmiges Außenvolumen zwischen zwei in etwa parallelen Seiten aufweist, wobei die eine dieser Seiten die Koppelseite (222) ist, und die andere, deren Flächenausdehnung größer ist, als jene der besagten Koppelseite, dazu bestimmt ist, bei der Belastung thermisch an die Quelle (20) zur thermischen Belastung gekoppelt zu werden.

3. Vorrichtung (2) nach einem der Ansprüche 1 bis 2, **dadurch gekennzeichnet, dass** sie Mittel zum Bestimmen der Strukturmerkmale des Schaltkreises (1) umfasst, sowie Mittel zum Erstellen der Öffnung im Gehäuse (12) in Abhängigkeit von den besagten Strukturmerkmalen.

4. Vorrichtung (2) nach einem der vorherigen Ansprüche, **dadurch gekennzeichnet, dass** sie eine Vielzahl von Koppelgliedern (22) umfasst, deren Enden (220) unterschiedliche Geometrien aufweisen.

5. Vorrichtung (2) nach einem der vorherigen Ansprüche, **dadurch gekennzeichnet, dass** jedes Koppelglied (22) einen internen Kanal (224) umfasst, der in die Koppelseite (222) seines Endes (220) mündet, und sich dazu eignet, einen optischen Zugriff auf den Elektronik-Chip (10) zu gewähren, wenn die Koppelseite dieses Koppelglieds an einer Seite (102) des Elektronik-Chips (10) angelegt wird.

6. Verfahren zur Belastung eines integrierten Schaltkreises (1) einen Elektronik-Chip (10) umfassend, der in einem Gehäuse (12) montiert ist, **dadurch gekennzeichnet, dass** es folgendes umfasst:
- einen Schritt (50) zur thermischen Kopplung eines Endes (220) eines wärmeleitenden Koppelglieds an eine Seite (102) des Elektronik-Chips (10) durch das Einführen des besagten Endes in eine zuvor im Gehäuse (12) eingerichtete Öffnung, wobei die besagte Öffnung einen mechanischen Zugriff auf eine Seite (102) des Elektronik-Chips (10) zulässt,
- einen Schritt (51) zur thermischen Belastung des Elektronik-Chips (10) anhand einer Quelle (20) zur thermischen Belastung, die thermisch an das Koppelglied (22) gekoppelt ist.

7. Verfahren nach Anspruch 6, umfassend einen vorherigen Schritt (52) zur Erstellung der Öffnung durch die Bearbeitung des Gehäuses (12) des integrierten Schaltkreises (1).

8. Verfahren nach Anspruch 7, **dadurch gekennzeichnet, dass** es einen Schritt (53) zur Bestimmung der Strukturmerkmale des integrierten Schaltkreises (1) umfasst, wobei die Öffnung im Gehäuse (12) in Abhängigkeit von den besagten Strukturmerkmalen erstellt wird.

9. Verfahren nach einem der Ansprüche 6 bis 8, **dadurch gekennzeichnet, dass** es einen Schritt (54) zur Auswahl eines Koppelglieds (22) aus einer Vielzahl von Koppelgliedern (22) umfasst, deren Enden (220) unterschiedliche Geometrien aufweisen, das sich zur Einführung in die Öffnung des Gehäuses (12) eignet.

10. Verfahren nach einem der Ansprüche 6 bis 9, **dadurch gekennzeichnet, dass** es einen Schritt (55) zur Strahlungsbelastung des Elektronik-Chips (10) durch die Öffnung umfasst, die im Gehäuse (12) des integrierten Schaltkreises (1) eingerichtet ist, vorzugsweise durch einen internen Kanal (224) des Koppelglieds (22), wobei der besagte interne Kanal in die Koppelseite (222) des Endes (220) des Koppelglieds mündet.

## Claims

1. Device (2) for stressing an integrated circuit (1) comprising an electronic chip (10) mounted in a housing (12), the device comprising a source (20) of thermal stress, and being **characterized in that** it comprises a thermally conductive coupling member (22), designed to be thermally coupled to the source (20) of thermal stress during the stressing operation, and **in that** the coupling member (22) comprises an end (220) whose geometry is suitable for being introduced into an aperture with a predefined geometry to be made in the housing (12) of the integrated circuit (1), said aperture allowing a mechanical access to a face (102) of the electronic chip (10), so as to thermally couple a coupling face (222) of this end (220) with the face (102) of the electronic chip (10).

2. Device (2) according to claim 1, **characterized in that** the coupling member (22) has a substantially tapered external volume between two substantially parallel faces; one of these faces is the coupling face (222) and the other, with a surface area substantially greater than said coupling face, is designed to be thermally coupled to the source (20) of thermal stress during the stressing operation.

3. Device (2) according to one of claims 1 to 2, **characterized in that** it comprises means for determining structural characteristics of the integrated circuit (1) and means for making the aperture in the housing (12) according to said structural characteristics.

4. Device (2) according to one of the preceding claims, **characterized in that** it comprises a plurality of coupling members (22) whose ends (220) have different geometries.

5. Device (2) according to one of the preceding claims, **characterized in that** each coupling member (22) comprises an internal duct (224) emerging on the coupling face (222) of its end (220), adapted to provide optical access to the electronic chip (10) when the coupling face of this coupling member is applied against the non-working face (102) of the electronic chip (10).

6. Method for stressing an integrated circuit (1) comprising an electronic chip (10) mounted in a housing (12), **characterized in that** it comprises:
- a step (50) of thermally coupling an end (220) of a thermally conductive coupling member with a face (102) of the electronic chip (10), by inserting said end into an aperture previously formed in the housing (12), said aperture allowing a mechanical access to said face (102) of the electronic chip (10),
- a step (51) of thermally stressing the electronic chip (10) by means for a source (20) of thermal stress thermally coupled to the coupling member (22).

7. Method according to claim 6, comprising a prior step (52) of making the aperture by machining the housing (12) of the integrated circuit (1).

8. Method according to claim 7, **characterized in that** it comprises a step (53) of determining structural characteristics of the integrated circuit (1), the aperture in the housing (12) being made according to said structural characteristics.

9. Method according to one of claims 6 to 8, **characterized in that** it comprises a step (54) of selecting a coupling member (22), from a plurality of coupling members (22) with ends of different geometries, adapted to be introduced into the aperture of the housing (12).

10. Method according to one of claims 6 to 9, **characterized in that** it comprises a step (55) of radiation stressing the electronic chip (10) through the aperture formed in the housing (12) of the integrated circuit (1), preferably via an internal duct (224) of the coupling member (22); said internal duct emerges on the coupling face (222) of the end (220) of the coupling member.
